**Europäisches Patentamt**

(19) **European Patent Office**

**Office européen des brevets**

(11) Numéro de publication : **0 227 521 B1**

(12) **FASCICULE DE BREVET EUROPEEN**

(45) Date de publication du fascicule du brevet :
06.02.91 Bulletin 91/06

(51) Int. Cl.$^5$ : **H04L 25/49, H03M 5/14**

(21) Numéro de dépôt : **86402550.7**

(22) Date de dépôt : **18.11.86**

(54) **Procédé de codage en code CMI d'informations numériques organisées en trame, le dispositif de mise en oeuvre, et son application à des informations de servitude pour réseau numérique à grand débit.**

(30) Priorité : **19.11.85 FR 8517037**

(43) Date de publication de la demande :
**01.07.87 Bulletin 87/27**

(45) Mention de la délivrance du brevet :
**06.02.91 Bulletin 91/06**

(84) Etats contractants désignés :
**DE GB IT**

(56) Documents cités :
**US-A- 4 520 480
REVIEW OF THE ELECTRICAL
COMMUNICATION LABORATORIES, vol. 31,
no. 3, mai 1983, pages 253-258, Tokyo, JP; N.
YOSHIKAI et al.: "F-400M line terminal
equipment"
REVIEW OF THE ELECTRICAL
COMMUNICATION LABORATORIES, vol. 31,
no. 6, novembre 1983, pages 844-852, Tokyo,
JP; Y. KOBAYASHI et al.: "Non-repeatered
submarine optical transmission terminal
equipment"
JAPAN TELECOMMUNICATIONS REVIEW,
vol. 23, no. 2, avril 1981, pages 125-134, Surrey,
GB; T. HORIGUCHI et al.: "F-32M and F-100M
fiber optic transmission systems"**

(56) Documents cités :
**ELECTRONICS AND COMMUNICATIONS IN
JAPAN, vol. 65-B, no. 4, avril 1982, pages
56-66, Silver Spring, Maryland, US; T. KITAMI
et al.: "Line codes and repeater fault location
schemes for optical transmission systems"
NATIONAL TELECOMMUNICATIONS
CONFERENCE, 29 novembre - 3 décembre
1981, pages G1.1.1-G1.1.5, IEEE, New Orleans,
Louisiana, US; T. KIHARA et al.: "Optical
data-transmission equipment for computer
systems (Optical data mux)"
PATENTS ABSTRACTS OF JAPAN, vol. 8, no.
59 (E-232)[1496], 17 mars 1984; & JP-A-58 209
253 (SONY K.K.) 06-12-1983**

(73) Titulaire : **SAT Société Anonyme de
Télécommunications
41, rue Cantagrel
F-75624 Paris Cedex 13 (FR)**

(72) Inventeur : **Arnaune, Jean-Pierre
41 rue Cantagrel
F-75631 Paris Cedex 13 (FR)**
Inventeur : **Dominguez, Nazario
41 rue Cantagrel
F-75631 Paris Cedex 13 (FR)**
Inventeur : **Walraet, Jean
41 rue Cantagrel
F-75631 Paris Cedex 13 (FR)**

(74) Mandataire : **Bloch, Gérard et al
2, square de l'Avenue du Bois
F-75116 Paris (FR)**

## Description

La présente invention concerne le codage d'informations en code CMI et plus particulièrement le codage d'informations numériques multiplexées organisées par exemple en trame (c.f. par exemple document "Review of the Electrical Communication Laboratories, vol 31, n°3, mai 1983, pages 253-258, Tokio, Japon)

Le code CMI est bien connu. Un tel code a par exemple fait l'objet de l'avis G 703 pages 55 à 57 du CCITT tel que remanié à Genève en 1980. Le code CMI est un code à deux niveaux sans retour à zéro du signal. Un 0 binaire à l'entrée est codé en un signal de niveau $A_1$ et $A_2$ (resp. niveau bas ou niveau haut) dans chaque demi-période (temps T/2). Un "1" binaire à l'entrée est codé en un signal de niveau $A_1$ ou $A_2$ sur une période, ce niveau alternant pour des "1" binaires successifs. On peut exprimer encore le code CMI plus simplement en disant que un "1" binaire est codé 00 et 11 alternativement et un "0" binaire est codé 01.

Toutefois, lorsque le train binaire d'informations résulte du multiplexage d'une pluralité de signaux organisés en trame, pour reconnaître ces signaux, il est nécessaire de prévoir un mot de verrouillage de trame. Or, l'insertion d'un tel mot peut perturber la statistique du code même.

La présente invention vise à pallier cet inconvénient. A cet effet, elle a tout d'abord pour objet un procédé de codage d'informations numériques en code CMI, dans lequel lesdites informations sont organisées en trames comprenant chacune un emplacement pour un mot V de verrouillage de trame, procédé caractérisé par le fait qu'on choisit pour ledit mot V l'élément binaire 1, qu'on viole le code CMI à l'emplacement dudit mot, et qu'on insère, immédiatement avant ledit mot V, un élément binaire B de remplissage, le dit élément binaire B étant choisi pour que la statistique de la loi de codage soit conservée globalement.

L'invention se propose d'utiliser pour mot de verrouillage de trame un "1" binaire placé en fin de trame. Cet élément binaire V serait donc codé en code CMI 11 ou 00. Pour le reconnaître, on convient de violer le code CMI à l'emplacement du mot V de verrouillage de trame en le codant 00 s'il devait être codé 11, ou 11 s'il devait être codé 00.

Toutefois, le codage de ce mot V ne tient pas compte des informations utiles contenues dans la trame et l'invention se propose, pour respecter la statistique de la loi de codage CMI, d'utiliser l'avant dernier élément binaire B de la trame, pour effectuer un remplissage de chaque trame.

Avantageusement, pour conserver globalement la statistique de la loi de codage, on choisit un viol à l'emplacement dudit mot V alternativement égal à 11 et 00, d'une trame à la suivante, et on choisit ledit élément binaire B :
— égal à 0 en binaire si le nombre de "1" des informations utiles de la trame avant introduction desdits éléments binaires B et V est impair,
— égal à 1 en binaire si ledit nombre est pair.

En effet, le niveau moyen d'énergie du signal peut être perturbé si la statistique du code CMI n'est pas respectée, c'est-à-dire si le nombre de "1" binaires codés 11 est différent du nombre de "1" binaires codés 00. Pour ce qui concerne les 0 binaires, ce problème n'existe pas du fait de leur codage en 01 en CMI.

Le procédé de l'invention permettant de respecter la statistique de la loi de codage consiste donc essentiellement à rechercher dans chaque trame la parité du nombre "1" et à coder l'élément binaire B de telle sorte que, lorsque le nombre de "1" en binaire avant remplissage est pair, l'élément binaire B est codé de façon identique à l'élément binaire de verrouillage de trame et lorsque le nombre de "1" en binaire avant remplissage est impair, l'élément binaire est codé 01.

L'invention vise également à procurer un dispositif particulièrement simple et efficace mettant en oeuvre le procédé précédent.

A cet effet, elle a pour objet un dispositif comprenant des moyens pour coder, en code CMI, un signal binaire organisé en trames comprenant chacune un emplacement pour un mot V de verrouillage de trame, dispositif caractérisé par le fait que :
— lesdits moyens de codage sont agencés pour violer, à l'emplacement dudit mot de verrouillage V choisi égal à 1, le code CMI,
— il est prévu des moyens pour insérer, immédiatement avant ledit mot V, un élément binaire B de remplissage, et,
— il est prévu des moyens recevant les informations utiles contenues dans la trame, pour déterminer la valeur dudit élément binaire B, de telle sorte que la statistique de la loi de codage soit conservée globalement.

Avantageusement :
— il est prévu des moyens pour maintenir à zéro la valeur dudit signal binaire à l'emplacement dudit mot V,

– lesdits moyens de codage sont agencés pour insérer, à l'emplacement dudit mot V, un viol alternativement égal à 11 et 00, d'une trame à la suivante,

– lesdits moyens de détermination de la valeur dudit élément binaire B sont agencés pour que :

– B = 0 en binaire si le nombre de "1" des informations utiles de la trame avant introduction desdits éléments binaires B et V est impair,

– B = 1 en binaire si ledit nombre est pair.

Avantageusement encore :

lesdits moyens de détermination comprennent :

– des moyens pour détecter la parité dudit nombre,

– une porte OU exclusif, recevant le signal de sortie desdits moyens de détection et un signal représentatif du codage dudit viol

– la sortie de ladite porte OU exclusif délivrant un signal représentatif de la valeur de l'élément binaire B.

Le procédé de l'invention s'applique en particulier au codage des informations de servitude telles que la supervision, la signalisation, les voies d'ordre, les alarmes, la télésurveillance d'un réseau de transmission numérique à grand débit, lesdites informations étant multiplexées en trames.

Cette voie de servitude numérique, codée selon le procédé de l'invention peut alors appliquée en ligne de façon connue en elle-même pour moduler un laser, par exemple.

D'autres avantages et caractéristiques apparaîtront à la lecture de la description suivante illustrée par des dessins.

La figure 1 est un schéma d'un dispositif permettant le codage des informations multiplexées en code CMI dans une trame de 32 éléments binaires.

La figure 2 représente un diagramme des temps des signaux disponibles aux sorties des éléments du dispositif de la figure 1.

On va exposer dans la description suivante le cas d'une trame de 32 éléments binaires, mais l'invention s'appliquerait de la même façon à une trame comportant un nombre quelconque d'éléments binaires.

Le procédé de codage en code CMI selon l'invention consiste, d'une part, à choisir pour mot de verrouillage de trame le dernier élément binaire de la trame binaire, d'autre part, à adopter pour ce mot V de verrouillage de trame un "1" binaire. De plus, ce mot V de verrouillage de trame est violé dans son codage en code CMI, c'est à dire que s'il devait, du fait du dernier "1" binaire de la trame, être codé 11 et non 00, il ne sera pas codé conformément au code CMI 11 mais 00 et réciproquement. Le procédé de codage du mot V de verrouillage de trame, en outre, doit s'adapter à la structure de trame des informations multiplexées et, pour la statistique du code CMI, on convient d'alterner à chaque trame le codage de ces viols.

Pour remplir toutes ces exigences apparemment difficiles à rendre compatibles, on utilise selon l'invention, dans chaque trame, l'avant dernier élément binaire B pour, d'une part, remplir toutes ces exigences sur le mot V de verrouillage de trame, d'autre part, pour respecter la statistique de la loi de codage CMI. Cet élément binaire B est donc un simple élément binaire de remplissage et son codage dépend donc, d'une part, de celui du mot de verrouillage de trame V qui est imposé par celui de la trame précédente et, d'autre part, des informations utiles contenues dans la trame.

Cet élément binaire B de remplissage peut donc selon les cas être codé, en code CMI, 01, 11 ou 00 selon les besoins. Si, dans la trame binaire, le nombre de "1" avant remplissage est pair, alors on adopte pour B la même valeur, en code CMI, que pour le mot V de verrouillage de trame.

Par contre, si le nombre de "1" dans la trame binaire avant remplissage est impair, on adopte pour B la valeur, en code CMI, 01.

Divers exemples suivants de trame illustrent le choix du bit $B_2$ de remplissage en fonction du mot $V_2$ de verrouillage de trame et du contenu utile de la trame, ce mot $V_2$ étant lui-même fonction du mot $V_1$ de la trame précédente.

| | Trame 1<br>$V_1$ | Trame 2 | $B_2$ | $V_2$ |
|---|---|---|---|---|
| ex 1 | ........ 11 | ....... 00 ...... 11 | 00 | 00 |
| ex 2 | ........ 11 | ....... 00 ...... 11 ... 00 | 01 | 00 |
| ex 3 | ........ 00. | ....... 11 ...... 00 | 11 | 11 |
| ex 4 | ........ 00 | ....... 11 ...... 00 ... 11 | 01 | 11 |

On remarquera que, à chaque fois, $V_2$ est opposé à $V_1$. Dans l'exemple 1, $B_2$ est choisi égal à 00 car le nombre de "1" binaires est pair donc $B_2$ égale $V_2$. Dans l'exemple 2, $B_2$ est choisi égal à 01 car le nombre de "1" binaires dans la trame est égal à trois, donc impair. Dans l'exemple 3, le nombre de "1" binaires est égal à deux, donc pair et $B_2$ est codé égal à $V_2$. Dans l'exemple 4, le nombre de "1" binaires est égal à 3, donc impair, donc $B_2$ est égal à 01. On a représenté uniquement les "1" binaires et supposé que les autres éléments binaires d'informations de la trame étaient des "0" binaires, donc codés 01 en CMI, donc sans effet sur la statistique.

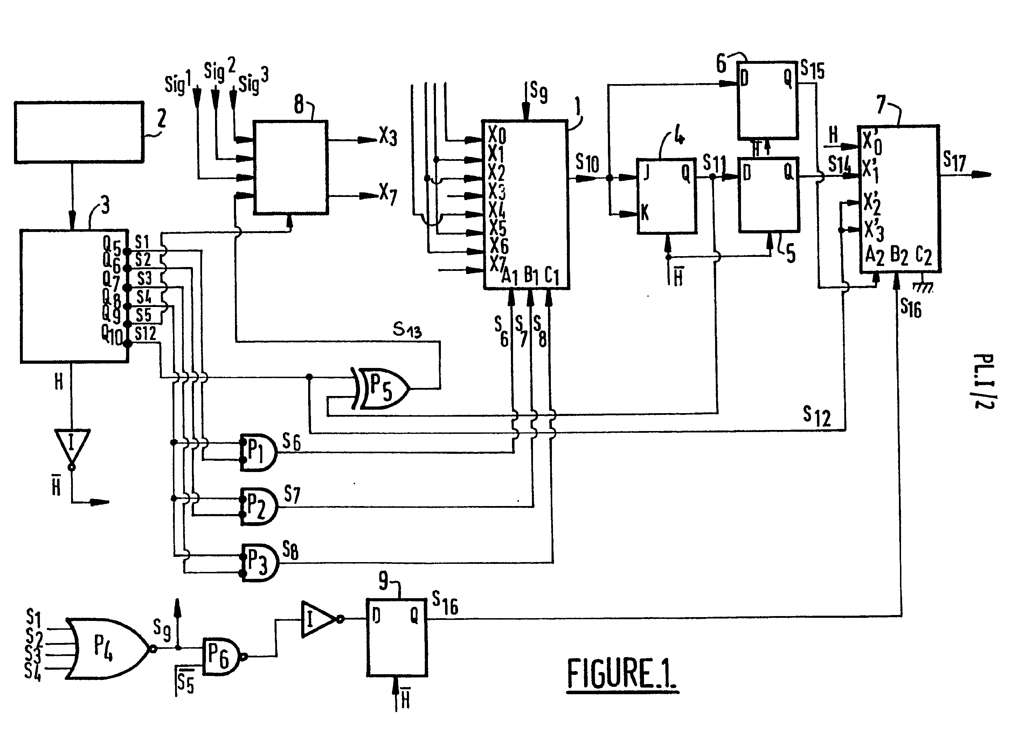

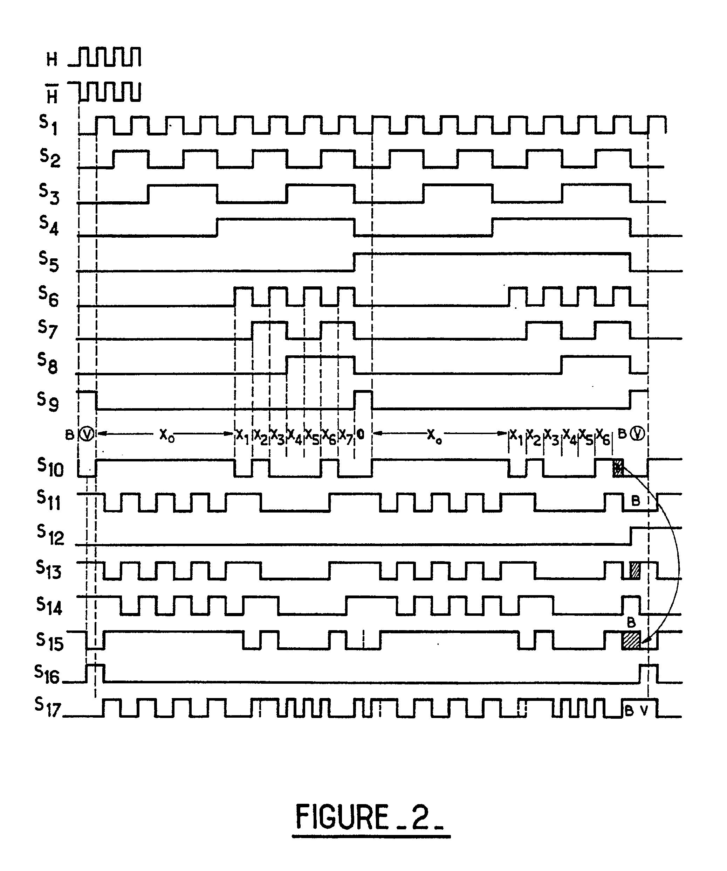

En se référant à la figure 1, un multiplexeur 1 reçoit les informations numériques $x_0$, $x_1$, $x_2$, $x_3$, $x_4$, $x_5$, $x_6$, $x_7$ en parallèle. Ces informations peuvent, par exemple, être des informations de service et avoir été préalablement codées en code binaire. Il peut s'agir, par exemple, d'informations de télésurveillance, de signalisation, d'informations de supervision, de voies d'ordre et d'alarmes dans un réseau de transmission numérique à grand débit, comportant par exemple un émetteur laser. Ce multiplexeur 1 fournit en sortie des informations en série, au débit convenable. Le signal d'horloge H ici de fréquence 128 Khz est par exemple déduit d'un oscillateur local 2, ici de fréquence 2,048 Mhz, grâce au circuit de division 3. Le signal $\overline{H}$ est déduit de H grâce à l'inverseur I. Le circuit de division 3 reçoit donc le signal de fréquence 2,048 Mhz et fournit sur les sorties $Q_5$, $Q_6$, $Q_7$, $Q_8$, $Q_9$, et $Q_{10}$ les signaux $S_1$, $S_2$, $S_3$, $S_4$, $S_5$, et $S_{12}$ respectivement, déduits du signal d'entrée par division par 32, 64, 128, 256, 512, et 1024 respectivement. Les signaux $S_1$ et $S_4$ sont appliqués à l'entrée d'une porte ET $P_1$ pour former un signals $S_6$ qui est appliqué à l'entrée de commande $A_1$, de rang le plus bas,du multiplexeur 1. Les signaux $S_2$ et $S_4$ sont appliqués à l'entrée d'une porte ET $P_2$ qui fournit en sortie un signal $S_7$ à l'entrée de commande $B_1$, de rang suivant, du multiplexeur 1. Les signaux $S_4$ et $S_3$ sont appliqueés à l'entrée d'une porte ET $P_3$ pour former le signal $S_8$ qui est appliqué à l'entrée de commande $C_1$, de rang le plus élevé, du multiplexeur 1. Ces divers signaux sont représentés sur le diagramme des temps de la figure 2. Le multiplexeur 1 peut par exemple être un C MOS 4512 de Motorola. Un signal $S_9$ d'inhibition est appliqué également à l'entrée Inhibit de ce multiplexeur 1. L'utilité de ce signal $S_9$ est liée à l'insertion du bit V de verrouillage en fin de chaque trame ainsi qu'il sera explicité ultérieurement. Ce signal $S_9$ est par exemple généré par une porte $\overline{OU}$ $P_4$ qui reçoit en entrée les signaux $S_1$, $S_2$, $S_3$, $S_4$, fournis par le circuit 3 de division. Ce signal $S_9$ est un signal repérant l'emplacement V du verrouillage en fin de chaque trame, et dans l'exemple particulier décrit, le seizième bit de chaque trame. Il permet de maintenir à 0 l'état du signal $S_{10}$ en sortie du multiplexeur 1 à ces amplacements V de verrouillage, et ici aux emplacements du seizième bit de chaque trame.

Ce signal $S_{10}$ est appliqué simultanément aux entrées J et K d'une bascule JK fonctionnant au rythme $\overline{H}$. Cette bascule JK est insensible aux "0" binaires appliqués en entrée et ne prend en compte que les "1" binaires, qui provoquent chacun le changement de son signal de sorties $S_{11}$.

On peut donc dire que la bascule JK détecte la parité du nombre de "1" des informations utiles de la trame avant introduction des éléments binaires B et V. Ce signal $S_{11}$ est appliqué, d'une part, à l'entrée d'une bascule 5 de type D, d'autre part, à l'entrée d'une porte OU exclusif $P_5$. Cette porte $P_5$ reçoit également le signal $S_{12}$. En effet, le signal $S_{12}$ est un signal de parité du viol du mot V de verrouillage de trame qui change d'état à chaque trame. Le signal $S_{11}$ quant à lui est un signal enregistrant les "1" binaires du signal utile d'informations (bit V de verrouillage de trame exclu puisque le signal $S_9$ inhibit assure la mise à zéro du signal $S_{10}$ à cet emplacement). De ce fait, en sortie de la porte $P_5$, le signal $S_{13}$ contient, à l'emplacement du bit B de remplissage, sa valeur binaire 0 ou 1, suivant la parité du nombre de 1 indiquése par le signal $S_{11}$. Il est ainsi aisé, comme dans le cas particulier de la figure 1, de le multiplexer préalablement avec certaines informations utiles, mais il pourrait également être appliqué directement à l'entrée du multiplexeur 1.

Ainsi, comme représenté sur la figure 1, un multiplexeur 8 reçoit ici sur quatre entrées des informations Sig 1, Sig 2, Sig 3, dont la nature sera précisée ultérieurement, et l'élément B de remplissage, pour fournir sur deux sorties les données $x_3$ et $x_7$ à l'entrée du multiplexeur 1. Ce multiplexeur 8 est commandé par le signal $S_5$ issu du circuit 3 de division.

Comme on l'a dit antérieurement le signal binaire $S_{11}$ à la sortie de la bascule 4 de type JK est appliqué à l'entrée d'une bascule 5 de type D, fonctionnant au rythme d'horloge $\overline{H}$, dont la fonction essentielle est de délivrer un signal $S_{14}$ identique au signal $S_{11}$, mais calé en phase avec le signal $\overline{H}$ d'horloge. Le signal binaire $S_{10}$ est également appliqué à l'entrée d'une bascule 6 de type D afin d'y subir également un calage sur l'horloge $\overline{H}$, ce qui donne le signal $S_{15}$. On constate que ce signal $S_{15}$ est globalement identique au signal binaire $S_{10}$, au bit B de remplissage près, qui y est inséré en vraie grandeur alors que ce bit B n'est présent que pendant un demi-temps d'horloge sur le signal $S_{10}$, à cause du retard dans la bascule JK 4.

Enfin, le codage du signal binaire proprement dit est effectué selon l'invention au moyen d'un circuit 7 de codage CMI.

Ce circuit 7 est ici un multiplexeur, par exemple CMOS de type 4512 de Motorole. Il reçoit sur ses entrées $x'_0$ et $x'_1$, le signal H d'horloge et le signal $S_{14}$, respectivement, et, sur ses entrées $x'_2$ et $x'_3$ réunies, le signal $S_{12}$.

Les signaux de commande de ce multiplexeur 7 sont : sur l'entrée de commande $A_2$, de rang le plus bas, le signal $S_{15}$, et, sur l'entrée de commande $B_2$, de rang suivant, un signal $S_{16}$ déterminant l'emplacement du bit V de verrouillage de trame, l'entrée de commande $C_2$ de rang de plus élevé étant appliquée à zéro.

Le signal $S_{16}$ est ici déduit du signal $S_9$ par application de ce signal $S_9$ à l'entrée d'une porte $P_6$ $\overline{ET}$ qui reçoit également le signal $\overline{S_5}$, obtenu à l'aide d'un inverseur non représenté, à partir du signal $S_5$.

La sortie de la porte $P_6$ est reliée à l'entrée D d'une bascule 9 après inversion du signal au moyen d'un inverseur I. La bascule 9 est rythmée par le signal $\overline{H}$ d'horloge et fournit en sortie le signal $S_{16}$. La table de vérité du multiplexeur 7 permet de déduire que $x'_0$ code les "0" binaires en recopiant le signal H d'horloge tandis que $x'_1$ code les "1" binaires. Les entrées $x'_2$ et $x'_3$ codent le bit V de verrouillage. En sortie, on obtient le signal $S_{17}$ d'informations organisées en trame et codées en code CMI selon l'invention.

On remarquera que, sur l'exemple de la figure 1, les informations appliquées aux entrées $x_1$ à $x_7$ du multiplexeur 1 sont partiellement prémultiplexées, par exemple au moyen du multiplexeur 8. En effet, lorsqu'il s'agit par exemple d'informations de servitude, formées par exemple de voies d'ordre, de signalisation, de supervision, de télésurveillance, d'alarmes, etc..., les débits de chacune de ces voies sont inégaux et on organise une trame en fonction de la quantité d'informations nécessaires pour chaque service. Si par exemple le débit global des informations de servitude est fixé à 128 kbit/S, comme dans l'exemple de la description, il suffit de répartir les éléments binaires utiles entre les diverses servitudes. On peut ainsi attribuer, dans l'exemple de l'invention :

```
   - 64 kbit/s pour la voie audio omnibus (entrée x )
                                                     0
   -  8 kbit/s pour la voie de télésurveillance (entrée x )
                                                          4
   - 16 kbit/s pour la voie d'ordres pour la sécurisation
     (entrées x  et x  reliées)
               1     5
   - 16 kbit/s pour la voie de supervision (entrées x  et
                                                     2
     x  reliées)
      6
   -  4 kbit/s pour une première voie de signalisation)
     (sig 1)                                          ) (en-
                                                      ) trée
   -  4 kbit/s pour une deuxième voie de signalisation) x )
                                                          3
     (sig 2)                                          )

   -  4 kbit/s pour une voie de signalisation RON/TRON) (en-
     de la voie audio (Sig 3)                         ) trée
                                                       ) x )
   -  4 kbit/s pour le bit de remplissage B           )   7
   -  4 kbit/s pour le bit de verrouillage
```

Dans le cas particulier qui vient d'être décrit, compte tenu que fait que le signal $S_9$ est au niveau 1 à l'emplacement du seizième bit de la trame, le signal $S_{10}$ est obligatoirement à zéro pendant ce seizième bit, qui pourrait être utilisé pour une signalisation de défaut amont, par exemple. L'insertion de cette signalisation en aval du multiplexeur 1, non représentée dans un souci de simplicité, est à la portée de l'homme de métier. Naturellement, on pourrait également fabriquer et appliquer, sur l'entrée d'inhibition du multiplexeur 1, un signal au niveau haut seulement pendant le mot V de verrouillage, et insérer alors la signalisation de défaut amont sur l'entrée $x_0$, au moment du seizième bit de la trame.

Un tel multiplexage permet la réalisation, grâce au codage CMI de l'invention, d'une trame de 32 éléments binaires pour voies de servitude d'un réseau de transmission à haut débit.

Une telle structure de trame peut évidemment être modifiée pour s'adapter au nombre de voies à multiplexer, au débit en ligne, et réaliser une trame d'un nombre quelconque d'éléments binaires.

Le choix du débit 128 kbit/s présente un intérêt tout particulier pour la voie de servitudes. En effet, comme mentionné dans le brevet français 2 526 554 de la demanderesse, un tel signal numérique peut servir à surmoduler en fréquence un émetteur laser. Ce débit de 128 kbit/s est certes une contrainte pour cette application bien particulière de formation de trame pour informations numériques codées en code CMI.

## Revendications

1. Procédé de codage d'informations numériques en code CMI, dans lequel, lesdites informations sont organisées en trames comprenant chacune un emplacement pour un mot V de verrouillage de trame, procédé caractérisé par le fait qu'on choisit pour ledit mot V l'élément binaire 1, qu'on viole le code CMI à l'emplacement dudit mot, et qu'on insère, immédiatement avant ledit mot V, un élément binaire B de remplissage, ledit élément binaire B étant choisi pour que la statistique de la loi de codage soit conservée globalement.

2. Procédé selon la revendication 1, dans lequel pour conserver globalement la statistique de la loi de codage, on choisit un viol à l'emplacement dudit mot V alternativement égal à 11 et 00, d'une trame à la suivante, et on choisit ledit élément binaire B :
   - égal à 0 en binaire si le nombre de "1" des informations utiles de la trame avant introduction desdits éléments binaires B et V est impair,
   - égal à 1 en binaire si ledit nombre est pair.

3. Dispositif pour la mise en oeuvre du procédé selon l'une des revendications 1 et 2, comprenant des moyens (3, 4, 5, 6, 7) pour coder, en code CMI, un signal binaire ($S_{10}$) organisé en trames comprenant chacune un emplacement pour un mot V de verrouillage de trame, dispositif caractérisé par le fait que :
   - lesdits moyens de codage (3, 4, 5, 6, 7) sont agencés pour violer, à l'emplacement dudit mot de verrouillage V choisi égal à 1, le code CMI,
   - il est prévu des moyens (8,1) pour insérer, immédiatement avant ledit mot V, un élément binaire B de remplissage, et,
   - il est prévu des moyens (4, P5), recevant les informations utiles contenues dans la trame, pour déterminer la valeur dudit élément binaire B, de telle sorte que la statistique de la loi de codage soit conservée globalement.

4. Dispositif selon la revendication 3, dans lequel :
   - il est prévu des moyens (3, P4) pour maintenir à zéro la valeur dudit signal binaire ($S_{10}$) à l'emplacement dudit mot V,
   - lesdits moyens de codage (3, 4, 5, 6, 7) sont agencés pour insérer, à l'emplacement dudit mot V, un viol alternativement égal à 11 et 00, d'une trame à la suivante,
   - lesdits moyens de détermination (4, P5) de la valeur dudit élément binaire B sont agencés pour que:
   - B = 0 en binaire si le nombre de "1" des informations utiles de la trame avant introduction desdits éléments binaires B et V est impair,
   - B = 1 en binaire si ledit nombre est pair.

5. Dispositif selon la revendication 4, dans lequel lesdits moyens de détermination (4, P5) comprennent:
   - des moyens (4) pour détecter la parité dudit nombre,
   - une porte OU exclusif (P5), recevant le signal de sortie ($S_{11}$) desdits moyens de détection (4) et un signal ($S_{12}$) représentatif du codage dudit viol,
   - la sortie de ladite porte OU exclusif (P5) délivrant un signal ($S_{13}$) représentatif de la valeur de l'élément binaire B.

6. Dispositif selon la revendication 5, dans lequel lesdits moyens de détection comprennent une bascule JK(4) dont les entrées J et K sont reliées.

7. Dispositif selon l'une des revendications 5 ou 6, dans lequel lesdits moyens de codage comprennent:
– un circuit d'horloge (3),
– des moyens (4) pour détecter la parité du nombre de "1" des informations utiles de la trame avant introduction desdits éléments binaires B et V,
– des premiers moyens (5) pour caler en phase le signal de sortie ($S_{11}$) desdits moyens de détection (4),
– des deuxièmes moyens (6) pour caler en phase ledit signal binaire ($S_{10}$),
– un multiplexeur (7), commandé par le signal de sortie ($S_{15}$) desdits deuxièmes moyens de calage et un signal ($S_{16}$) représentatif de l'emplacement dudit mot V, et recevant sur ses entrées un signal d'horloge (H), le signal de sortie ($S_{14}$) desdits premiers moyens de calage (5), et un signal ($S_{12}$) représentatif du codage dudit viol, pour délivrer un signal ($S_{17}$) codé en code CMI, représentant ledit signal binaire ($S_{10}$) dont les "0" binaires sont codés par ledit signal d'horloge (H), les "1" binaires par ledit signal de sortie ($S_{14}$) desdits premiers moyens de calage (5), un viol du code CMI ayant lieu à l'emplacement dudit mot V.

8. Procédé de codage d'informations numériques codées en code CMI selon l'une des revendications 1 ou 2, appliqué au cas où lesdites informations sont des informations de servitude telles que la supervision, la signalisation, les voies d'ordre, les alarmes, la télésurveillance d'un réseau de transmission numérique à grand débit, lesdites informations étant multiplexées en trames.

9. Procédé selon la revendication 8 dans lequel la voie numérique formée desdites informations de servitude module un émetteur laser.

## Ansprüche

1. Kodierungsverfahren zur Kodierung digitaler Informationen im Kode CMI, in welchem die Informationen in Rastern angeordnet sind, wobei jede eine Stelle für ein Wort V zur Rasterverriegelung umfaßt, dadurch gekennzeichnet, daß für das Wort V das binäre Element 1 gewählt wird, daß der Kode CMI an der Stelle des Wortes V verletzt wird, und daß unmittelbar vor dem Wort V ein binäres Füllelement B eingefügt wird, wobei das binäre Element B gewählt wird, damit die Statistik des Kodierungsgesetzes insgesamt gewahrt ist.

2. Verfahren nach Anspruch 1, bei welchem zur insgesamten Bewahrung der Statistik des Kodierungsgesetzes an der Stelle des Wortes V abwechselnd von einem Raster zum folgenden eine Verletzung gleich 11 bzw. 00 gewählt und das binäre Element B wie folgt gewählt wird :
– gleich 0 im Binärsystem, wenn die Zahl von "1" en der Nutzinformationen des Rasters vor Einführung der Elemente B und V ungerade ist,
– gleich 1 im Binärsystem, wenn die genannte Zahl gerade ist.

3. Einrichtung zur Durchführung des Verfahrens nach einem der Ansprüche 1 und 2, welche Mittel (3, 4, 5, 6, 7) zur CMI-Kodierung, eines in Rastern angeordneten binären Signals (S10) umfaßt, wobei jede eine Stelle für ein Wort V zur Verriegelung des Rasters umfaßt, dadurch gekennzeichnet, daß
– die Kodierungsmittel (3, 4, 5, 6, 7) zur Verletzung des CMI-Kodes an der Stelle des gleich 1 gewählten Verriegelungswortes ausgebildet sind,
– Mittel (8,1) vorgesehen sind, um unmittelbar vor dem Wort V ein binäres Füllelement B einzufügen, und,
– Mittel (4, P5) vorgesehen sind, die die im Raster enthaltenen Nutzinformationen empfangen, um den Wert des genannten binären Elements B derart zu bestimmen, daß nie Statistik des Kodierungsgesetzes insgesamt gewahrt ist.

4. Einrichtung nach Anspruch 3, in welcher :
– Mittel (3, P4) vorgesehen sind, um den Wert des binären Signals (S10) an der Stelle des Wortes V auf 0 zu erhalten,
– die Kodierungsmittel (3, 4, 5, 6, 7) zum von einem Raster zum folgenden abwechselnden Einfügen einer Verletzung gleich 11 bzw. 00, ausgebildet sind,
– die Mittel zur Bestimmung des Wertes (4, P5) des binären Elements B derart ausgebildet sind, damit
– B = 0 im Binärsystem dann ist, wenn die Zahl von "1" en der Nutzinformationen des Rasters vor Einführung der genannten binären Elemente B und V ungerade ist,
– B = 1 im Binärsystem dann ist, wenn die genannte Zahl gerade ist.

5. Einrichtung nach Anspruch 4, in welcher die genannten Bestimmungsmittel (4, P5) umfassen :
– Mittel (4) zum Erkennen der Parität der genannten Zahl,
– ein Exklusiv-ODER-Tor (P5), das das Ausgangssignal (S11) der Paritäts-Erkennungsmittel (4) und ein der Kodierung der genannten Verletzung repräsentatives Signal (S12) empfängt,
– wobei der Ausgang des Exklusiv-ODER-Tores (P5) ein Signal (S13) liefert, das den Wert des binären Elementes B repräsentiert.

6. Einrichtung nach Anspruch 5, in welcher die Paritäts-Erkennungsmittel ein JK-Flip-Flop (4) umfassen, deren Eingänge J und K verbunden sind.

7. Einrichtung nach einem der Ansprüche 5 oder 6, in welcher die Kodierungsmittel umfassen :
– einen Taktschaltkreis (3),
– Mittel (4), um die Parität der Zahl von "1" en der Nutzinformation des Rasters vor Einführung der binären Elemente B und V zu erkennen,
– erste Mittel (5), um das Ausgangssignal (S11) der Erkennungsmittel (4) in Phase zu stellen,
– zweite Mittel (6), um das genannte binäre Signal (S10) in Phase zu stellen,
– einen Multiplexer (7), der durch das Ausgangssignal (S15) der zweiten In-Phasen-Stellungs-Mittel und durch ein Signal (S16), das stellvertretend für die Stelle des genannten Wortes V ist, gesteuert wird, und der an seinen Eingängen ein Taktsignal (H), das Ausgangssignal (S14) der ersten genannten In-Phasen-Stellungs-Mittel (5) und ein der Kodierung der Verletzung repräsentatives Signal (S12) empfängt, um ein im Kode CMI kodiertes Signal (S17) zu liefern, das das binäre Signal (S10) repräsentiert, bei welchem die binären "0"en durch das Taktsignal (H) und dessen binäre "1" en durch das Ausgangssignal (S14) der ersten In-Phasen-Stellungs-Mittel (5) kodiert sind, wobei eine Verletzung des Kodes CMI an der Stelle des Wortes V stattfindet.

8. Kodierungsverfahren zur Kodierung digitaler Informationen, im Kode CMI, nach einem der Ansprüche 1 oder 2, angewendet in dem Fall, in dem die genannten Informationen Dienstinformationen sind, wie Überwachung, Signalisierung, Ablauffolgen, Alarme und Fernüberwachung eines digitalen Hochleistungsübertragungsnetzes, wobei die genannten Informationen in Rastern gemultiplext sind.

9. Verfahren nach Anspruch 8, in welchem der Digitalkanal der aus den genannten Dienstinformationen gebildet ist, einen Laser-Sender moduliert.


## Claims

1. Method of coding digital information in the CMI code, in which said information is organized in frames each having a position for a frame locking word V, method characterised in that the binary element 1 is chosen for said word V, the CMI code is violated at the position of said word V and, immediately before said word V, is inserted a binary filling word B, said binary element B being chosen so that the overall statistics of the coding law are kept.

2. Method according to claim 1, wherein for keeping the overall statistics of the coding law, violation is chosen at the position of said word V alternately equal to 11 and 00, from one frame to the next, and said binary element B is chosen :
– equal to 0 in the binary system if the number of "1" s of useful information of the frame before introduction of said binary elements B and V is uneven,
– equal to 1 in the binary system if said number is even.

3. Device for implementing the method according to one of claims 1 or 2, including means (3, 4, 5, 6, 7) for coding, in the CMI code, a binary signal ($S_{10}$) organized in frames each comprising a position for a frame locking word V, device characterised in that :
– said coding means (3, 4, 5, 6, 7) are adapted for violating the CMI code at the position of said locking word V chosen equal to 1,
– means (8,1) are provided for inserting, immediately before said word V, a binary filling word B, and
– means (4, P5) are provided, responsive to the useful information contained in the frame, for determining the value of said binary element B, so that the overall statistics of the coding law are kept.

4. Device according to claim 3, wherein :
– means (3, P4) are provided for keeping the value of said binary signal ($S_{10}$) at zero at the position of said word V,
– said coding means (3, 4, 5, 6, 7) are adapted for inserting at the position of said word V, a violation alternately equal to 11 and 00, from one frame to the next,
– said means for determining (4, P5) the value of said binary element B are adapted so that :
– B = 0 in the binary system if the number of "1"s of the useful information of the frame before introduction of said binary elements B and V is uneven,
– B = 1 in the binary system if said number is even.

5. Device according to claim 4, wherein said determination means (4, P5) include :

8

– means (4) for detecting the parity of said number,

– an exclusive OR gate (P5) receiving the output signal ($S_{11}$) of said detection means (4) and a signal ($S_{12}$) representative of the coding of said violation,

– the output of said exclusive OR gate (P5) delivering a signal ($S_{13}$) representative of the value of said binary element B.

6. Device according to claim 5, wherein said detection means include a JK flip flop (4) whose J and K inputs are connected together.

7. Device according to one of claims 5 or 6, wherein said coding means include :

– a clock circuit (3),

– means (4) for detecting the parity of the number of "1" s of the useful information of the frame before introduction of said binary elements B and V,

– first means (5) for phase locking the output signal ($S_{11}$) of said detection means (4),

– second means (6) for phase locking said binary signal ($S_{10}$),

– a multiplexer (7), controlled by the output signal ($S_{15}$) of said second phase locking means and a signal ($S_{16}$) representative of the position of said word V, and receiving at its inputs a clock signal (H), the output signal ($S_{14}$) from said first phase locking means (5) and a signal ($S_{12}$) representative of the coding of said violation, so as to deliver a signal ($S_{17}$) coded in the CMI code representing said binary signal ($S_{10}$) whose binary "0"s are coded by said clock signal (11), and whose binary "1"s are coded by said output signal ($S_{14}$) from said first phase locking means (5), a violation of the CMI code taking place at the position of said word V.

8. Method of coding digital information coded in the CMI code according to one of claims 1 or 2, applied to the case where said information is servitude information such as supervision, signalling, order channels, alarms, remote monitoring of a high capacity digital transmission network, said information being multiplexed in frames.

9. Method according to claim 8, wherein the digital channel formed of said servitude information modulates a laser emitter.

PL.I/2

FIGURE 1.

FIGURE _2_